# EUROPÄISCHE PATENTANMELDUNG

(11) **EP 2 337 090 A1**
(43) Veröffentlichungstag der Anmeldung: **22.06.2011**
(21) Anmeldenummer: 10195586.2
(22) Anmeldetag: 17.12.2010
(51) Int. Cl.: H01L 31/18, H01L 31/042, H01L 31/0216, H01L 31/052

(54) **Verfahren zur Herstellung von semitransparenten Photovoltaikmodulen und Photovoltaikmodul**

(30) Priorität: 18.12.2009 DE 102009059208
(71) Anmelder: Malibu GmbH & Co. Kg, 33609 Bielefeld (DE)
(72) Erfinder:
(74) Vertreter: Dantz, Jan Henning

(57) **Zusammenfassung**

Verfahren zur Herstellung eines semitransparenten Dünnschicht-Photovoltaikmoduls, wobei das Photovoltaikmodul eine Anordnung von schichtweise aufgebauten Solarzellen (21, 31, 41, 51, 61, 21') mit zumindest einer Rückreflektorschicht (27, 37, 46, 56, 66) aufweist, wobei auf die Solarzellen (21, 31, 41, 51, 61, 21') eine farbaktive Schicht (28, 38, 48, 58, 68) aufgetragen wird, sowie ein Semitransparentes Photovoltaikmodul.

## Beschreibung

Die Erfindung betrifft ein Verfahren zum Herstellen eines semitransparenten Photovoltaikmoduls sowie ein semitransparentes Photovoltaikmodul nach den Oberbegriffen der Ansprüche 1 und 16.

In semitransparenten Photovoltaikmodulen sind Solarzellen derart angeordnet, dass es zur Ausbildung von opaken und transparenten Teilbereichen kommt. Während in opaken Teilbereichen die Solarzellen angeordnet sind, sind die Teilbereiche zwischen den Solarzellen aus transparenten Stoffschichten aufgebaut.

Dadurch ist es möglich, Objekte, welche sich hinter dem semitransparenten Photovoltaikmodul befinden, durch die transparenten Teilbereiche des Photovoltaikmoduls hindurch wahrzunehmen.

Bei einem bekannten Herstellungsverfahren eines Dünnschicht-Photovoltaikmoduls wird auf einem Substrat eine Front-Elektrodenschicht angeordnet. Auf dieser wird eine Absorberschicht aufgebracht, die Lichtenergie teilweise in Elektrizität, aufgrund des photoelektrischen Effekts, umwandelt. Auf der Absorberschicht werden eine Rück-Elektrodenschicht angeordnet und schließlich eine Rückreflektorschicht. Diese beiden Schichten können auch zu einer Schicht zusammengefasst sein.

Die Schichtabfolge wird durch die Reihenfolge der Abscheidung der Schichten auf dem Substrat und durch eine anschließende Laserstrukturierung bestimmt. Während der Bearbeitung des Dünnschicht-Photovoltaikmoduls werden beispielsweise durch eine Laserstrukturierung oder durch Ätzen die metallischen Schichten aus den transparenten Teilbereichen entfernt, so dass eine semitransparente Oberfläche entsteht.

Bei der Verwendung der semitransparenten Dünnschicht-Photovoltaikmodule als Fassadenelement sind auf deren Unterseite bzw. deren sonnenabgewandte Seite die Solarzellen als entweder metallische oder weißgraue Oberflächen zu erkennen.

Die metallischen Oberflächen unterliegen jedoch Spiegeleffekten, während die weißgrauen Oberflächen zumeist einen hohen Kontrast zu dem Hintergrund einnehmen. Diese Effekte werden von einem Betrachter in der Regel als unangenehm und störend empfunden.

Die Erfindung setzt daher bei der Aufgabe an, semitransparente Dünnschichtmodule und ein Verfahren zu dessen Herstellung bereitzustellen, die einen verbesserten optischen Eindruck bei Betrachtung der sonnenabgewandten Seite bzw. bei einem Blick durch das Modul zu von einem Innenraum nach außen ermöglichen.

Die Erfindung löst diese Aufgabe durch die Merkmale der Ansprüche 1 und 16.

Vorteilhafte Ausgestaltungen der Erfindung sind den Unteransprüchen zu entnehmen.

Erfindungsgemäß wird bei einem Verfahren zur Herstellung eines semitransparenten Photovoltaikmoduls mit einer Anordnung von schichtweise aufgebauten Solarzellen eine farbaktive Schicht (Farbschicht) auf die Solarzellen aufgetragen, jedoch nicht auf die transparenten Bereiche, so dass die Semitransparenz der Module erhalten bleibt.

Der Auftrag erfolgt auf der Unterseite, also der sonnenabgewandten Seite des Photovoltaikmoduls.

Dadurch werden der optische Eindruck der Oberfläche des Photavoltaikmoduls und die Kontrastbiltlung zum Hintergrund verbessert. Dies erleichtert dem Betrachter die Betrachtung des Moduls und die Wabrnehmung von Objekten die hinter einem derartigen Modul angeordnet sind.

Das Photovoltaikmodul kann beispielsweise als Dünnschicht-Modul die Glasfront und/oder Außenhülle eines Gebäudes bilden.

Insbesondere Spiegel- oder Lichteffekte behindern den Betrachter nicht mehr in der Wahrnehmung.

Das Aufbringen der Farbe kann derart erfolgen, dass die Farbe die Solarzellen ganz oder zumindest bereichsweise bedeckt.

Für eine hohe Kontrastbildung ist es jedoch von Vorteil, wenn die Farbe die Solarzelle zu mindestens 80%, vorzugsweise vollständig bedeckt.

Der gewünschte Farbeindruck kann vorteilhaft durch Materialien mit Schwarzoder Brauntönen, wie beispielsweise Kohlenstoff oder Fe₃O₄ erreicht werden oder mit Materialien, welche sich nach dem Aufbringen in eine Verbindung mit dunkler Farbe umwandeln. Weitere mögliche Materialien sind Pigmentfarben oder Interferenzfarben.

Das Auftragen der farbaktiven Schicht erfolgt vorteilhaft ohne weitere Vorbehandlung direkt auf die Rückreflektorschicht der Solarzelle.

Bei einer ersten Verfahrensvariante erfolgt das Auftragen der farbaktiven Schicht auf die Rückreflektorschicht der Solarzelle nach einer Laserstrukturierung der Rückreflektorschicht, so dass das Modul vor dem Auftragen der farbaktiven Schicht bereits opake Teilflächen im Bereich der Solarzellen und transparente Teilflächen in den Bereichen zwischen den Solarzellen aufweist und das Auftragen der farbaktiven Schicht lediglich auf die opaken Teilflächen erfolgt. Dabei können vorteilhaft auch bereits funktionstüchtige Solarmodule mit einer farbaktiven Schicht nachträglich versehen werden.

Bevorzugt erfolgt Auftragen der farbaktiven Schicht vorteilhaft als Siebdruck und/oder als Digitaldruck, wobei auch Mehrfarbendruckmotive vorteilhaft auf die Oberfläche der Photovoltaikmodule aufgebracht werden können.

Zum Schutz des Farbmotivs oder des Druckmusters kann die farbaktive Schicht zusätzlich mit einer transparenten Folien- und/oder Glasschicht versehen werden.

In einer zweiten Verfahrensvariante erfolgt das Aufbringen der farbaktiven Schicht auf das Photovoltaikmodul dadurch, dass die farbaktive Schicht zunächst auf eine transparente Folie und/oder Glasschicht aufgetragen wird, die im Anschluss auf die Unterseite des Photovoltaikmoduls aufgebracht wird. Die Unterseite des Photovoltaikmoduls ist dabei die sonnenabgewandte Seite. Diese Variante des Auftragens einer farbaktiven Schicht ist insofern von Vorteil, dass die Berührung eines Drucksiebes mit den empfindlichen Oberflächen der Solarzellen vermieden wird.

In einer dritten Verfahrenvariante erfolgt das Auftragen der farbaktiven Schicht über die gesamte Oberfläche des Photovoltaikmoduls, wobei die transparenten Teilflächen der semitransparenten Struktur durch eine anschließende Laserbehandlung unter Entfernung der farbaktiven Schicht herausgebildet werden. Das Auftragen der farbaktiven Schicht, kann im Gegensatz zu der ersten Verfahrensvariante, vor dem Strukturieren der Rückreflektorschicht, also im Herstellungsprozess des Moduls erfolgen, wodurch die farbaktive Schicht zunächst breitflächig auf der Oberfläche des Moduls appliziert wird und durch den anschließenden Strukturierungsschritt ein gleichzeitiges Entfernen der Farb- und Rückreflektorschicht von den transparenten Teilbereichen zwischen den Solarzellen erfolgt.

In einer vierten Verfahrensvariante erfolgt das Auftragen der farbaktiven Schicht durch Ausbildung einer Positivmaske, indem zunächst ein eingefärbter Fotolackes auf die Unterseite des semitransparenten Photovoltaikmoduls bevorzugt breitflächig aufgebracht wird. Anschließend erfolgt das Aushärten des Lackes in den Bereichen, welche bei Bestrahlung von der Oberseite nicht oder nur gering belichtet werden. Wenn der Fotolack in diesen Bereichen, in welchen die Solarzellen angeordnet sind, ausgehärtet ist, kann bei einem anschließenden Reinigungsschritt, beispielsweise durch ein Lösemittel, lediglich als der unausgehärtete Fotolack aus den belichteten Bereichen entfernt werden Der ausgehärtete eingefärbte Farblack verbleibt jedoch auf der Oberfläche des Moduls.

In einer fünften Verfahrensvariante erfolgt das Auftragen der farbaktiven Schicht durch Ausbildung einer Negativmaske, indem zunächst ein Fotolackes auf die Unterseite des Photovoltaikmoduls aufgetragen wird. Anschließend erfolgt das Aushärten des Lackes in den Bereichen, welche bei Bestrahlung von der Oberseite belichtet werden. Wenn der Fotolack in den transparenten Bereichen zwischen den Solarzellen ausgehärtet ist, kann bei einem anschließenden Reinigungsschritt, beispielsweise durch ein Lösemittel, lediglich als der unausgehärtete Fotolack aus den unbelichteten Bereichen entfernt werden Der ausgehärtete eingefärbte Fotolack verbleibt jedoch auf der Oberfläche des Moduls und bildet einen Film über den transparenten Bereichen des Moduls. Anschließend kann der vorzugsweise breitflächige Auftrag einer farbaktiven Schicht erfolgen. Anschließend kann der Fotolackfilm mit der darauf anhaftenden farbaktiven Schicht mit einem anderen Lösemittel, welches in der Lage ist den ausgehärteten Fotolackfilm, jedoch nicht die farbaktive Schicht von dem Modul abzulösen, entfernt werden.

Um Berührungen der Oberfläche während des Farbauftrages zu vermeiden, ist es von Vorteil, den Farbauftrag durch einen Sputterprozess zu gewährleisten. Dabei wird die Unterseite des Moduls mit Atomen beschichtet, welche vorher durch Kathodenzerstäubung aus einem Substrat herausgelöst wurden, in die Gasphase gelangt sind und anschließend auf der Oberfläche des Moduls kondensiert sind. Diese Art des Farbauftrags bedarf darüber hinaus keines zusätzlichen apparativen Aufbaus einer Druckvorrichtung oder dergleichen, da die metallische Rückreflektorschicht zumeist ebenfalls durch ein Sputterverfahren auf das Modul aufgebracht wird

Nachfolgend wird die Erfindung durch mehrere Ausführungsbeispiele näher charakterisiert. Sie zeigen:
- Fig.1: schematische Darstellung eines bekannten Schichtaufbaus einer ersten Dünnschicht-Solarzelle;
- Fig.2: schematische Darstellung eines bekannten Schichtaufbaus einer zweiten Dünnschicht-Solarzelle;

- Fig.3: schematische Darstellung der Anordnung von zwei Solarzellen eines erfindungsgemäßen semitransparenten Photovoltaikmod uls;
- Fig.4: schematische Detaildarstellung einer ersten erfindungsgemäßen Ausführungsvariante einer Solarzelle eines Photovoltaikmoduls;
- Fig.5: schematische Detaildarstellung einer zweiten erfindungsgemäβen Ausführungsvariante einer Solarzelle;
- Fig.6: schematische Detaildarstellung einer dritten erfindungsgemäßen Ausführungsvariante einer Solarzelle; und
- Fig.7: schematische Detaildarstellung einer vierten erfindungsgemäßen Ausführungsvariante einer Solarzelle;

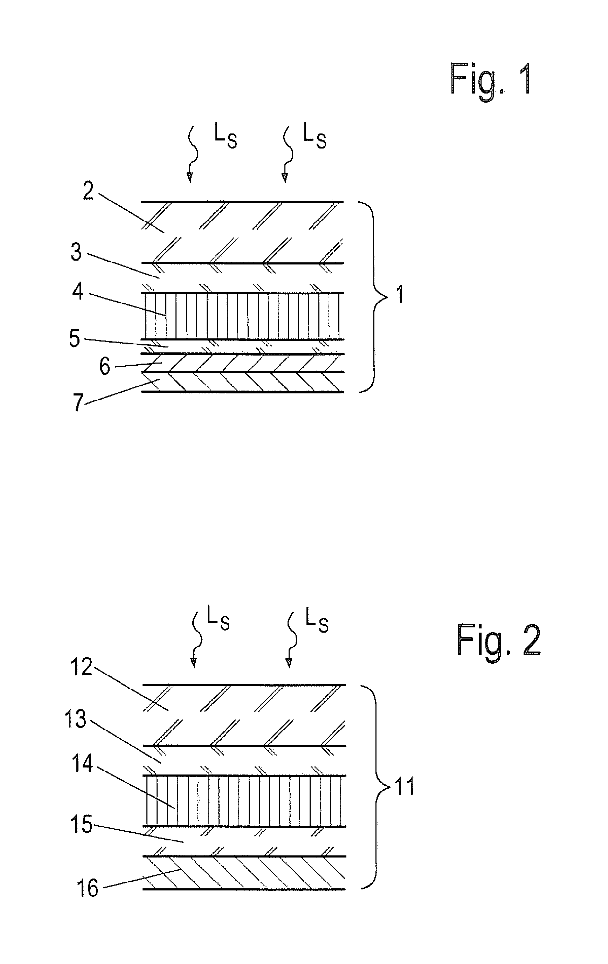

Fig. 1 zeigt den Schichtaufbau einer Dünnschicht-Solarzelle 1 nach dem Stand der Technik.

Dabei weist die Solarzelle 1 ein Substrat 2, beispielsweise aus Glas, auf. Das Substrat 2 ist dabei transparent und im Wesentlichen inert gegenüber Umwelteinflüssen.

Auf der sonnenabgewandten Seite des Substrates 2 ist eine Front-Elektrodenschicht 3 aus einer transparenten leitfähigen Schicht (TCC-Schicht) angeordnet. Das Schichtmaterial ist dabei eine fluordotierte Zinnoxidschicht.

Auf der Front-Elektrodenschicht wird eine Absorberschicht 4 aufgebracht, die Lichtenergie Lₛ unter Erzeugung eines elektrischen Stroms und elektrischer Energie teilweise umwandelt. Diese Schicht kann beispielsweise als p-i-n Abfolge aus amorphem H-dotiertem Silicium oder aus amorph-mikrokristallinem H-dotierten Silicium als Tandemzelle aufgebaut sein.

Auf die Absorberschicht 4 wird eine weitere transparente leitfähige Schicht (TCO-Schicht) 5 angeordnet.

Auf der Schicht 5 ist eine Rückreflektorschicht 6 aufgebracht, welche zudem eine Schicht zur Rückkontaktierung 7 aufweist. Die Rückreflektorschicht 6 besteht dabei aus einer Aluminiumschicht, während die Schicht der Rückkontaktierung 7 aus einer Nickel/Vanadium Legierung gebildet wird.

Fig. 2 zeigt den Schichtaufbau einer weiteren Dünnschicht-Solarzelle 11 nach dem Stand der Technik.

Dabei weist die Solarzelle 11 ein Substrat 12 beispielsweise aus Glas auf. Das Substrat 12 ist dabei transparent und inert gegenüber Umwelteinflüssen.

Auf der sonnenabgewandten Seite des Substrates 12 ist eine Front-Elektrodenschicht 13 aus einer transparenten leitfähigen Schicht aus bordotiertem Zinkoxid angeordnet.

Auf dieser Schicht wird eine Absorberschicht 14 in einer p-i-n Abfolge aus amorphem H-dotiertem Silicium oder aus amorph-mikrokristallinem H-dotierten Silicium als Tandemzelle aufgebracht.

Auf der Absorberschicht 14 ist eine weitere transparente leitfähige Schicht (TCO-Schicht) 15 aus bordotiertem Zinkoxid für die Rückkontaktierung angeordnet.

Auf die TCO-Schicht 15 ist eine Rückreflektorschicht 16, aus Titandioxidpigmenten aufgebracht.

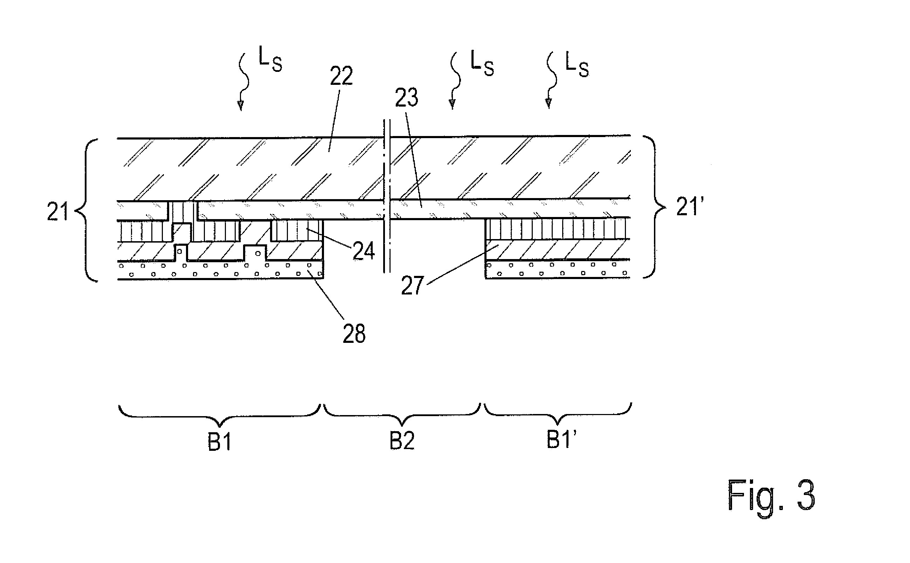

Fig. 3 zeigt ausschnittsweise die Anordnung von zwei Dünnschicht-Solarzellen 21 und 21' in einem erfindungsgemäßen Photovoltaikmodul.

Dabei weisen die jeweiligen Solarzellen 21 eine Substratschicht 22, eine Front-Elektrodenschicht 23, eine Absorberschicht 24 und eine Schicht zur Rückkontaktierung 27 auf.

Die Solarzelle 21, 21' erstreckt sich über einen Teilbereich B1, B1 des Photovoltaikmoduls. Lediglich ein geringer bis gar kein Anteil des einfallenden Lichtes Lₛ kann durch die Solarzelle 21, 21' dringen. Daher erscheinen die Teilereiche B1 der Solarzellen 21, 21' nicht transparent sondern opak, also trüb bis lichtundurchlässig.

Die Bereiche B2 zwischen den Solarzellen 21 weisen hingegen lediglich transparente Schichtabfolgen auf, welche einfallendes Sonnenlicht Lₛ ungehindert durchdringen kann. Durch diese Anordnung ist die Semitransparenz des Photovoltaikmoduls gewährleistet.

Auf die Schicht zur Rückkontaktierung 27 ist erfindungsgemäß eine farbaktive Schicht 28 aufgebracht. Diese Farbschicht besteht aus dunklen Farbtönen, welche einen Kontrast zu hellen Hintergründen bildet. Dadurch ist ein angenehmerer Anblick des Photovoltaikmoduls für den Betrachter ermöglicht.

Als dunkle Farbtöne sind nach dem Modell des RGB Farbraums alle diese Farbtöne zu verstehen, welche im Farbraum um mindestens 5% der Gesamtlänge der Raumdiagonalen (Weißpol-Schwarzpol) vom Weißpol beabstandet sind.

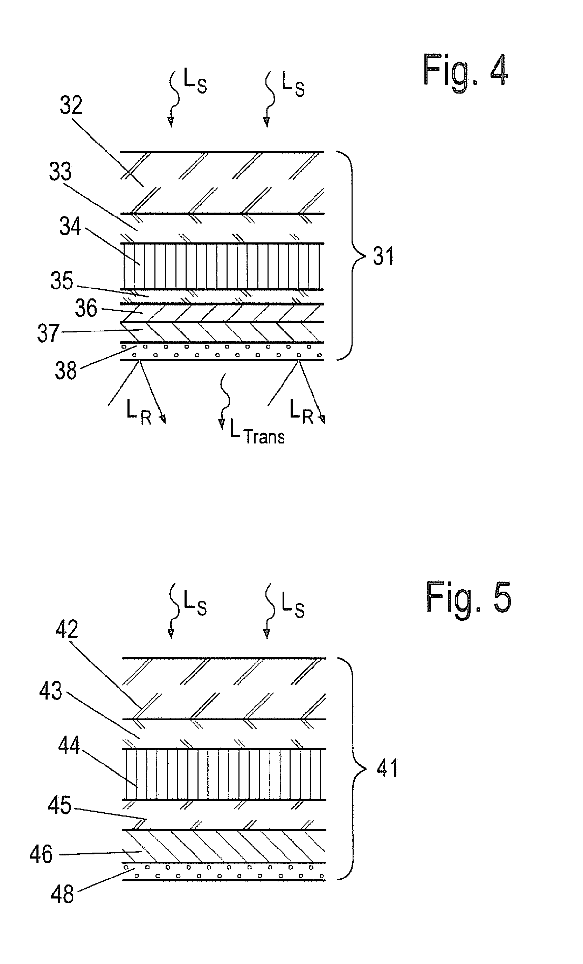

Fig. 4 zeigt die Detailansicht einer erfindungsgemäßen Solarzelle 31 mit einem mehrschichtigen Aufbau. Die Schichtabfolge der oberen Schichten entspricht der Schichtabfolge des zuvor genannten Ausführungsbeispiels.

Sie zeigt eine Siliciumoxidschicht 32, eine TCO-Schicht 33 aus fluordotiertem Zinnoxid, eine amorphe oder amorph-mikrokristalline Silicium-Absorberschicht 34, eine weitere TCO-Schicht 35, eine Aluminiumschicht 36 und eine Nickel/Vanadiumschicht 37.

Auf die Nickel/Vanadiumschicht 37 ist erfindungsgemäß eine Farbe 38 aufgebracht, welche in ihren Auftragsdicken und in ihrem Dunkelgrad (Anzahl der Farbpigmente, Verdünnungsgrad, usw.) variierbar ist.

Der Dunkelgrad der farbaktiven Schicht 38 bestimmt sich aus dem Transmissionsgrad der Zelle 31 gegenüber dem einfallenden Licht Lₛ. Der transmittierte Anteil des einfallenden Lichts L_{Trans} wird dabei nicht durch das an der Innenseite reflektierte Licht L_{R}, beispielsweise aus dem Gebäudeinneren, überdeckt.

Der Farbton der farbaktiven Schicht 38 kann entsprechend variieren und vorzugsweise schwarz, braun, blau oder grün sein.

Figur 5 zeigt einen weiteren schichtweisen Aufbau einer erfindungsgemäßen Solarzelle 41. Sie weist als Außenschicht zunächst eine Siliciumdioxidschicht 42 auf, an welche sich eine TCO-Schicht 43 zur Frontkontaktierung anschließt. Auf diese transparenten Schichten folgt eine opake Absorberschicht 44, welche nach der p-i-n Schichtfolge aufgebaut ist. Daran schließt sich eine weitere TCO-Schicht 45, vorzugsweise aus bordotiertem Zinkoxid an. Diese transparente Schicht dient der Rückkontaktierung mit der frontkontaktierten TCO-Schicht. Auf die TCO-Schicht ist eine Schicht mit Titandioxid 46 aufgebracht. Diese Schicht ermöglicht die Reflektion von eintreffender Strahlung und erhöht somit den Wirkungsgrad der Solarzelle 41.

Auf diese Reflexionsschicht ist eine dunkle farbaktive Schicht 48 aufgebracht, welche die Unterscheidung zwischen den opaken und transparenten Bereichen für das Auge des Betrachters erleichtert.

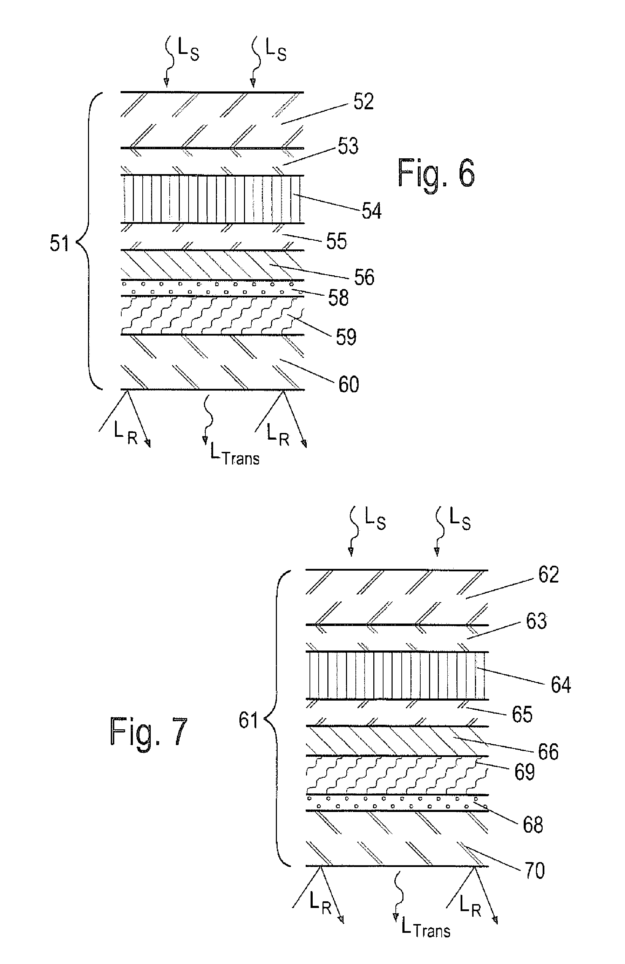

In Figur 6 zeigt die Anordnung einer weiteren erfindungsgemäßen Ausführungsform mit einer Solarzelle 51 mit z.T. analoger Schichtfolge mit Bezug auf Fig.3.

Sie weist somit eine Substratschicht 52, eine Front-Elektrodenschicht 53, eine Absorberschicht 54, und eine Schicht zur Rückkontaktierung 55und eine Rückreflektorschicht 56 und zudem weitere Schichten 58-60 auf.

Der Dunkelgrad der farbaktiven Schicht 58 bestimmt sich aus dem Transmissionsgrad der Zelle gegenüber dem einfallenden Licht Lₛ. Der transmittierte Anteil des einfallenden Lichts L_{Trans} wird dabei nicht durch reflektiertes Licht L_{R} aus dem Gebäudeinneren überdeckt.

Das aufgebrachte Druckmuster entspricht dem Muster der opaken Flächen, welche durch das Aufbringen der einzelnen Schichten der Solarzelle 51 gebildet werden.

Über der farbaktiven Schicht ist eine Schutzfolie 59, beispielsweise aus Kunststoff angeordnet. Die Zelle 51 weist schließlich noch ein Rückglas 60 auf und schützt die Zelle vor mechanischer Belastung.

Figur 7 zeigt die Schichtabfolge einer semitransparenten-leitfähige Solarzelle 61, wobei die oberen Schichten in einer Schichtabfolge und Funktionalität analog zur vorherigen Figur 6 angeordnet sind.

Auf die Schicht 66 zur Reflektion von Strahlen ist zunächst eine transparente Folie 69 aufgebracht. Darauf wird eine dunkle Farbeschicht 68 aufgebracht. Dies kann durch Drucken oder jede andere Auftragtechnik erfolgen, so dass das Muster der aufgetragenen farbaktive Schicht der Anordnung der Solarzellen im Modul entspricht.

Schließlich wird eine Glasschicht 70 auf die farbaktive Schicht 68 aufgebracht, um mechanischen Abrieb oder andere Umwelteinflüsse auf die farbaktive Schicht zu verhindern.

In einem erfindungsgemäßen Verfahren erfolgt zunächst das Bereitstellen eines Solarmoduls mit Solarzellen, welche zueinander derart beabstandet sind, dass das Solarmodul eine semitransparente Oberfläche bildet.

Dies kann beispielsweise derart erfolgen, dass auf einem Siliciumdioxid-Substrat schrittweise eine TCO-Schicht, z.B. aus fluordotiertem Zinnoxid oder bordotiertem Zinkoxid, eine p-i-n Siliciumschicht aus amorphen oder amorph-teilkristallinem Material und eine weiteren TCO-Schicht abgeschieden wird. Nach jedem Schritt des Abscheidens, erfolgt eine Laserstrukturierung der jeweils abgeschiedenen Schicht.

Beim Bereitstellen des Solarmoduls wird in einer Variante der Zuschnitt der Solarmodule nach der Ausbildung der Solarzellen und dem Aufbringen der farbaktiven Schicht vorgenommen. So erfolgen das Aufbringen der einzelnen Schichten der Solarzelle und deren Strukturierung zunächst auf einer beliebig großen Substratfläche. Das anschließende Aufbringen einer farbaktiven Schicht kann mit einem einzigen Standardsieb erfolgen, um beliebig große semitransparente Module zu bedrucken.

Dabei kann die farbaktive Schicht eine Schichtdicke von geringer als 1 µm aufweisen, um den gewünschten Abdunkelungseffekt zu erzielen.

Die Entscheidung über die Abmessungen und den Zuschnitt auf eine entsprechende Größe, sowie die Randentschichtung, durch welche auch die farbaktive Schicht entfernt wird, kann individuell vorgenommen werden.

Die Kontaktierung kann alternativ zur herkömmlichen Kontaktierung des Moduls auch mittels eines Leitklebers, parallel zu der freigelegten TCO-Beschichtung auf dem Siliciumdioxid-Substrat, erfolgen.

Auf die TCO-Schicht wird eine Reflektorschicht beispielsweise im Siebdruck derart aufgebracht, dass eine dunkle Farbe im Anschluss an das Aufbringen der weißen Titandioxid-Pigmentschicht in einem Doppeldruckverfahren aufgedruckt wird. Hierfür werden zum Bedrucken der weißen und dunklen farbaktive Schichten zwei Drucksiebe verwendet.

Das Druckbild wird durch die Anordnung mehrerer Zellen zu einem Modul vorgegeben. Wie bereits in den vorhergehenden Ausführungsbeispielen erörtert, richtet sich der Dunkelgrad der aufgetragenen farbaktive Schicht nach dem Transmissionsgrad der Photovoltaikmodule und deren Solarzellen.

Dieser Doppeldruck aus weißer und dunkler Farbe kann dabei vorteilhaft einen Trocknungsschritt zwischen dem ersten Aufbringen der weißen Farbe und dem zweiten Aufbringen der dunklen Farbe umfassen, um ein Vermischen beider Farben zu vermeiden,

Bei anderen Solarzellen, beispielsweise mit einer Nickel/Vanadiumschicht als Reflektorschicht, kann die dunkle Farbe direkt auf die metallische Oberfläche aufgebracht werden.

Bei der Verwendung von Drucksieben, kann auch ein Mehrfarbendruck auf die Oberfläche einer Solarzelle, beispielsweise auf eine Nickel/Vanadium oder Titanoxid-Oberfläche, erfolgen. Alternativ oder zusätzlich kann ein Mehrfarbendruckmuster im Digitaldruckverfahren auf die Oberfläche der Zelle aufgebracht werden.

Alternativ oder zusätzlich zu den beschriebenen Druckverfahren kann ein indirekter Farbauftrag erfolgen, indem zunächst eine transparente Folie, beispielsweise eine Laminatfolie, mit dem entsprechenden Farbmuster bedruckt wird. Die Folie kann anschließend derart auf das Solarmodul aufgebracht werden, dass das Foliendruckmuster deckungsgleich ist mit der Anordnung der Solarzellen auf dem Photovoltaikmodul.

Zusätzlich oder alternativ kann auch eine Glasschicht mit einer farbaktiven Schicht versehen werden und anschließend innenseitig deckungsgleich mit der Anordnung der Solarzellen auf das Modul aufgebracht werden.

Falls es sich bei der Rückreflektorschicht der Solarzellen um eine metallische Schicht handelt, können alternativ zum Farbauftrag durch Siebdruck auch weitere Möglichkeiten zum Einsatz kommen.

In einer derartigen Verfahrensvariante kann alternativ zum Siebdruckverfahren nach dem Aufbringen der metallischen Rückreflektorschicht und vor dem eigentlichen Strukturierungsschritt ein Farbauftrag erfolgen ("Sputterprozess").

Der Auftrag der farbaktiven Schicht kann breitflächig erfolgen, wobei die farbaktive Schicht vorzugsweise eine Schichtdicke von weniger als 1µm aufweist. Vorzugsweise ist die farbaktive Schicht dünner als der gesamte Schichtstapel aus den übrigen Schichten.

Im Anschluss kann durch einen Strukturierungsschritt der Oberfläche durch Laserbestrahlung sowohl die metallische Rückreflektorschicht als auch die aufgetragene Farbe an den Stellen zwischen den Zellen entfernt werden, so dass eine Transparenz dieser Stellen erreicht wird. Auf den opaken Bereichen des Solarmoduls bleibt jedoch die farbaktive Schicht erhalten. Für den Schichtauftrag sowohl beim Auftragen der metallischen Rückreflektorschicht, als auch der farbaktiven Schicht im darauffolgenden Schritt, kann ein Sputterprozess genutzt werden, so dass die Verwendung eines Drucksiebes nicht nötig ist. Dadurch werden homogene Schichtdicken im Sub-µm-Bereich erzeugt.

Für den dunklen Farbeindruck kann beispielsweise Fe₃O₄ oder Kohlenstoff genutzt werden. Alternativ oder zusätzlich kann zudem ein Material genutzt werden, welches sich auf einer Oberfläche durch eine anschließende Reaktion abdunkelt. Dies ist u.a. bei Silberverbindungen der Fall.

### Bezugszeichenliste

- 1, 11, 21, 31, 41, 51, 61, 21': Solarzelle
- 2, 12, 22, 32, 42, 52, 62: Substrat
- 3, 13, 23, 33, 43, 53, 63: Frontkontakt (TCO)
- 4, 14, 24, 34, 44, 54, 64: Absorber
- 5, 15, 35, 55, 65: TCO-Schicht
- 6, 27, 36, 45: Rückkontakt
- 7, 16,27,37,46,56,66: Rückreflektorschicht
- 28, 38, 48, 58, 68: farbaktive Schicht
- 59, 69: Folie
- 60, 70: Glasschicht
- Lₛ: Sonnenlicht
- L_{Trans}: transmittierte Strahlung
- L_{R}: reflektierte Strahlung
- B1: opaker Bereich
- B2: transparenter Bereich

## Patentansprüche

1. Verfahren zur Herstellung eines semitransparenten Dünnschicht-Photovoltaikmoduls, wobei das Photovoltaikmodul eine Anordnung von schichtweise aufgebauten Solarzellen (21, 31, 41, 51, 61, 21') mit zumindest einer Rückreflektorschicht (27, 37, 46, 56, 66) aufweist, **dadurch gekennzeichnet, dass** auf die Solarzellen (21, 31, 41, 51, 61, 21`) eine farbaktive Schicht (28, 38, 48, 58, 68) aufgetragen wird.

2. Verfahren nach Anspruch 1, **dadurch gekennzeichnet, dass** die farbaktive Schicht (28, 38, 48, 58, 88) jeweils eine Solarzelle (21, 31, 41, 51, 61, 21`) zu mindestens 80% bedeckt.

3. Verfahren nach Anspruch 1 oder 2, **dadurch gekennzeichnet, dass** die farbaktive Schicht (28, 38, 48, 58, 68) Kohlenstoff, Fe₃O₄ oder Silberverbindungen aufweist.

4. Verfahren nach einem der vorhergehenden Ansprüche, **dadurch gekennzeichnet, dass** die Kontaktierung des Moduls mittels eines Leitklebers erfolgt.

5. Verfahren nach einem der vorhergehenden Ansprüche, **dadurch gekennzeichnet, dass** nach dem Auftragen der farbaktiven Schicht (28, 38, 48, 58, 68) ein Zuschnitt des Moduls und/oder eine Randentschichtung erfolgt

6. Verfahren nach einem der vorhergehenden Ansprüche, **dadurch gekennzeichnet, dass** das Auftragen der farbaktiven Schicht (28, 38, 48, 58, 68) auf die Rückreflektorschicht (27, 37, 46, 56, 66) der Solarzelle (21, 31, 41, 51, 61, 21') erfolgt.

7. Verfahren nach einem der vorhergehenden Ansprüche, **dadurch gekennzeichnet, dass** das Auftragen der farbaktiven Schicht (28, 38, 48, 58, 68) auf die Rückreflektorschicht (27, 37, 46, 56, 66) der Solarzelle (21, 31, 41, 51, 61, 21') nach der Strukturierung der Rückreflektorschicht (27, 37, 46, 56, 66) erfolgt

8. Verfahren nach einem der vorhergehenden Ansprüche, **dadurch gekennzeichnet, dass** das Auftragen der farbaktiven Schicht (28, 38, 48, 58, 68) als Siebdruck und/oder als Digitaldruck erfolgt.

9. Verfahren nach einem der vorhergehenden Ansprüche, **dadurch gekennzeichnet, dass** auf die Unterseite des Photovoltaikmoduls eine transparente Folien- und/oder Glasschicht (59, 60, 69, 70) aufgetragen wird.

10. Verfahren nach einem der Ansprüche 1-5, **dadurch gekennzeichnet, dass** die farbaktive Schicht (28, 38, 48, 58, 68) auf eine transparente Folie und/oder Glasschicht (59, 60, 69, 70) aufgetragen wird, welche im Anschluss auf die Unterseite des Photovoltaikmoduls aufgebracht wird.

11. Verfahren nach Anspruch 1-6, **dadurch gekennzeichnet, dass** das Auftragen der farbaktiven Schicht über die gesamte Oberfläche des Photovoltaikmoduls erfolgt und die semitransparente Struktur durch eine anschließende Laserbehandlung derart erfolgt, dass die farbaktive Schicht (28, 38, 48, 58, 68) von den Bereichen außerhalb der Solarzellen (21, 31, 41, 51, 61, 21`) entfernt wird.

12. Verfahren nach Anspruch 1-6, **dadurch gekennzeichnet, dass** Auftragen der farbaktiven Schicht (28, 38, 48, 58, 68) nach folgenden Schritten verläuft:
A) Auftragen eines Fotolackes auf die Unterseite des Photovoltaikmoduls
B) Ausbilden einer Positivmaske bezogen auf die Anordnung der Solarzellen (21, 31, 41, 51, 61, 21 `) auf dem semitransparenten Photovoltaikmodul unter Einwirkung von Strahlung auf die Oberseite des Photovoltaikmoduls, wobei beim Ausbilden einer Positivmaske der Fotolack Farbstoffe enthält und der Lack in belichteten Bereichen des Photovoltaikmoduls löslich und der Lack in den unbelichteten Bereichen des Photovoltaikmoduls unlöslich ist; und
C) Entfernen des löslichen Lackes aus den belichteten Bereichen

13. Verfahren nach Anspruch 1-6, **dadurch gekennzeichnet, dass** Auftragen der farbaktiven Schicht (28, 38, 48, 58, 68) nach folgenden Schritten verläuft:
A) Auftragen eines Fotolackes auf die Unterseite des Photovoltaikmoduls
B) Ausbilden einer Negativmaske bezogen auf die Anordnung der Solarzellen auf dem semitransparenten Photovoltaikmodul unter Einwirkung von Strahlung auf die Oberseite des Photovoltaikmoduls, wobei beim Ausbilden einer Negativmaske der Lack in unbelichteten Bereichen des Photovoltaikmoduls in einen Reinigungsschritt löslich und der Lack in den belichteten Bereichen des Photovoltaikmoduls unlöslich ist; und
C) Entfernen des löslichen Lackes aus den belichteten Bereichen
D) Auftragen der farbaktiven Schicht (28, 38, 48, 58, 68) auf die Unterseite des
Photovoltaikmoduls
E) Antrocknen der farbaktiven Schicht (28, 38, 48, 58, 68) auf der Unterseite des
Photovoltaikmoduls
F) Ablösen der Negativmaske in einem zweiten Reinigungsschritt, in welchem die Komponenten der Negativmaske löslich sind.

14. Verfahren nach einem der Ansprüche 1-4 und 9-11, **dadurch gekennzeichnet, dass** die Reflektorschicht als metallische Schicht auf der Unterseite der Solarzelle (21, 31, 41, 51, 61, 21') abgeschieden wird.

15. Verfahren nach einem der vorhergehenden Ansprüche, **dadurch gekennzeichnet, dass** der Auftrag der farbaktiven Schicht (28, 38, 48, 58, 68)durch einen Sputterprozess erfolgt.

16. Semitransparentes Photovoltaikmodul, weiches opake und transparente Teilbereiche aufweist und die opaken Teilbereiche schichtweise übereinander geordnet eine Substratschicht (22, 32, 42, 52, 62), eine Frontelektrodenschicht (3, 13, 23, 33, 43, 53, 63), eine Absorberschicht (24, 34, 44, 54, 64), eine Rückelektrodenschicht (27, 35, 36, 45, 55, 65) und eine Rückreflektorschicht (27, 37, 46, 56, 66) aufweist, **dadurch gekennzeichnet, dass** auf der Rückreflektorschicht (27, 37, 46, 56, 66) eine farbaktive Schicht (28, 38, 48, 58, 68) angeordnet ist.
